# EUROPEAN PATENT APPLICATION

(11) **EP 4 764 698 A1**
(43) Date of publication of application: **24.06.2026**
(21) Application number: 23949852.0
(22) Date of filing: 30.10.2023
(51) Int. Cl.: G03F 1/64, G03F 7/20

(54) **EUV PELLICLE MOUNTING BLOCK HAVING STRESS BUFFERING STRUCTURE, EUV PELLICLE STRUCTURE INCLUDING MOUNTING BLOCK, EUV EXPOSURE APPARATUS HAVING EUV PELLICLE STRUCTURE, AND PELLICLE MOUNTING AND DEMOUNTING METHOD**

(30) Priority: 18.08.2023 KR 20230108166
(71) Applicant: Fine Semitech Corp., Hwaseong-si Gyeonggi-do 18487 (KR)
(72) Inventor: LEE, Soyoon, Hwaseong-si Gyeonggi-do 18487 (KR); PARK, Seonghwan, Hwaseong-si Gyeonggi-do 18487 (KR); CHOI, Jaehyuck, Hwaseong-si Gyeonggi-do 18487 (KR); SEO, Kyoungwon, Hwaseong-si Gyeonggi-do 18487 (KR); KIM, Yongsu, Hwaseong-si Gyeonggi-do 18487 (KR); KANG, Honggu, Hwaseong-si Gyeonggi-do 18487 (KR); YU, Lan, Hwaseong-si Gyeonggi-do 18487 (KR); KIM, Kyoungsoo, Hwaseong-si Gyeonggi-do 18487 (KR); PARK, Jinsu, Hwaseong-si Gyeonggi-do 18487 (KR); CHO, Sangjin, Hwaseong-si Gyeonggi-do 18487 (KR)
(74) Representative: LLR
(86) International application number: PCT/KR2023/016979
(87) International publication number: WO 2025/041912

(57) **Abstract**

The embodiment relates to a mounting block having a stress-absorbing structure, an EUV pellicle structure including the mounting block, an EUV exposure apparatus including the EUV pellicle structure, and a method of mounting and demounting the EUV pellicle.

A mounting block having a stress-absorbing structure according to the embodiment may include a mounting frame disposed in a first direction, a stress-absorbing body extending from the mounting frame in a second direction perpendicular to the first direction, and a stress-absorbing through-hole penetrating from a top to a bottom of the stress-absorbing body.

## Description

### [Technical field]

The embodiment relates to a mounting block of an EUV pellicle having a stress-absorbing structure, an EUV pellicle structure including the mounting block, an EUV exposure apparatus including the EUV pellicle structure, and a method of mounting and demounting an EUV pellicle.

For example, the embodiment may include a mounting block of an EUV pellicle with a mechanical stress-absorbing structure. Additionally, the embodiment may include a mounting block for the EUV pellicle having a thermal stress-absorbing structure. Additionally, the embodiment may include a mounting block for the EUV pellicle having a thermomechanical stress-absorbing structure.

The pellicle of the example may be applied to an extreme ultraviolet (EUV) exposure process, but is not limited thereto.

### [Background Art]

In the manufacture of semiconductor devices or liquid crystal displays, a photolithography process is used to pattern a semiconductor wafer or liquid crystal substrate.

In photolithography, a reticle or a photo mask is used as an original patterning substrate, and the pattern on the reticle is transferred to a semiconductor wafer or a liquid crystal substrate. However, when particles are attached to the reticle, light is absorbed or reflected by these particles, causing damage to the transferred pattern, resulting in a decrease in quality or yield of semiconductor devices or liquid crystal displays. Accordingly, a pellicle is used to prevent particles from attaching to the reticle surface.

When using a pellicle, the particles are not attached directly to the reticle surface, but on top of the pellicle, so during lithography. Accordingly, there is an advantage in that the particles on the pellicle are not transferred to the semiconductor wafer or liquid crystal substrate because they are out of focus and the focus can be aligned with the mask pattern.

Meanwhile, the resolution of semiconductor exposure equipment is increasing, and in order to realize the resolution, the wavelength of the source light source is becoming shorter and shorter.

For example, UV (Ultra Violet) light sources has been used G-ray (436nm), I-line (365nm), KrF excimer laser (248nm), and ArF excimer laser (193nm), but recently, the use of extreme ultraviolet rays (EUV, 13.5 nm) has been required due to the demand for patterning processes of less than 10 nm.

In other words, recently, semiconductor devices and liquid crystal displays have become increasingly highly integrated and miniaturized. For example, conventional technology for forming fine patterns of about 32 nm on a photoresist film can be handled by improved technologies using excimer lasers, such as liquid immersion exposure technology or multiple exposure that exposes the photoresist film using an ArF excimer laser (193 nm).

However, next-generation semiconductor devices and liquid crystal displays require the formation of finer patterns, but it is difficult to form such fine patterns using conventional pellicle and exposure technologies. Additionally, recently, EUV exposure technology using EUV light with a dominant wavelength of 13.5 nm has been attracting attention as a method for forming finer patterns.

In order to implement exposure technology using the EUV, the developments of new light sources, photoresists, reticles, and pellicles are necessary.

Meanwhile, due to the high wavelength energy of EUV, the transmittance of the pellicle membrane decreases to a level that requires replacement in about a week, so periodic replacement is inevitable.

However, in the internal technology, the pellicle frame is bonded to the reticle which is a mask substrate, using a fixing member such as glue or adhesive.

Accordingly, when demounting the pellicle from the reticle for membrane replacement, the pellicle frame is strongly fixed to the reticle with glue or adhesive. For this reason, the problem of pellicle membrane fracture occurs during the demounting step.

Meanwhile, the strength of the pellicle frame and the strength of the membrane border are major factors in demounting. However, materials with the strength to withstand the mechanical stress applied during demounting in very thin pellicle frames and membrane borders of around 1 mm or less are limited. In addition, materials with such strength have a high coefficient of thermal expansion (CTE), so there is a technical contradiction that causes the PID (Pellicle Induced Distortion) problem which will be described later.

For example, in pellicle technology, the materials of the pellicle frame and mask substrate that are in contact with each other are different, or the materials of the pellicle frame and pellicle membrane are different, causing PID (Pellicle Induced Distortion) problems due to differences in thermal characteristics.

Specifically, as the miniaturization of semiconductor devices or liquid crystal displays progresses, thermal stress occurs due to differences in coefficient of thermal expansion (CTE) when a pellicle is attached to a photo mask and an exposure process is performed. There is a PID issue where the photomask is deformed due to such thermal stress. As a result of PID, the positional accuracy of the pattern is misaligned, making it difficult to form fine patterns, and even damaging expensive mask substrates.

### [Disclosure]

### [Technical Problem]

One of the technical problems of the embodiment is not only to minimize the 'mechanical stress' applied to the pellicle frame and membrane border in the demounting step of the pellicle, but also to prevent PID (Pellicle Induced Distortion) by buffering or reducing 'thermal stress' caused by differences in the coefficient of thermal expansion (CTE) of the pellicle frame, mask substrate, and pellicle membrane in the exposure process.

For example, the embodiment aims to provide a method of demounting the pellicle without damaging the pellicle membrane by minimizing the mechanical stress applied to the thin pellicle frame and membrane border in the pellicle demounting step.

In addition, the embodiment aims to provide a method to prevent PID from occurring due to thermal stress due to a difference in the coefficient of thermal expansion (CTE) between the pellicle frame and the mask substrate or the pellicle frame and the pellicle membrane that are in contact with each other.

The technical problems of the embodiments are not limited to those described in this item, but include those that can be understood from the description of the invention.

### [Technical solution]

The mounting block 40 of the EUV pellicle according to the embodiment may include a mounting frame 420 disposed in a first direction (X), and a stress-absorbing body 410 extending from the mounting frame 420 in a second direction (Y) perpendicular to the first direction (X) and a stress-absorbing through-hole (T) penetrating from a top to a bottom of the stress-absorbing body 410.

The stress-absorbing through-hole (T) may extend in the first direction (X) and may include a first stress-absorbing through-hole T1 disposed in the stress-absorbing body 410.

The stress-absorbing through-hole (T) may include a second stress-absorbing through-hole T1 extending from one end of the first stress-absorbing through-hole T1 in a second direction (Y) perpendicular to the first direction (X), and
a third stress-absorbing through-hole T3 extending from the other end of the first stress-absorbing through-hole T1 in the second direction (Y).

The mounting frame 420 may include a first guide portion R1 on its upper surface.

The mounting block of the EUV pellicle of the embodiment may further include a mounting spacing member 430 that extends from the stress-absorbing body 410 in the negative (-) direction of the third direction (Z) perpendicular to the first direction and the second direction.

The mounting spacing member 430 may include an adhesive receiving groove.

The mounting block of the EUV pellicle of the embodiment may further include a mounting groove (H) disposed on the upper part of the stress-absorbing body 410.

The mounting groove (H) may vertically overlap the receiving groove of the mounting spacing member 430.

The mounting spacing member 430 may protrude from a bottom side of the stress-absorbing body 410.

The mounting block of the EUV pellicle of the embodiment may further include a single or a plurality of jig guide portions R2 disposed below the stress absorbing body 410.

The jig guide portion R2 may be disposed in opposite directions to the mounting frame 420.

The mounting block 402 of the EUV pellicle of the second embodiment may further include a mounting connection frame 422 connecting the stress-absorbing body 410.

In addition, the mounting block 403 of the EUV pellicle of the third embodiment may include a single or a plurality of demounting slots 410S on the side of the stress-absorbing body 410.

The demounting slot 410S may be arranged in opposite directions from the mounting frame 420.

The EUV pellicle structure 2000 according to the embodiment may be the EUV pellicle structure that fixes the pellicle frame on the reticle by one of the mounting blocks 400, 402, and 403.

In addition, the EUV pellicle structure 2000 may include a first adhesive disposed between the pellicle frame and the mounting frame 420 provided in one of the mounting blocks 400, 402, and 403.

Additionally, the EUV pellicle structure 2000 according to the embodiment may include a second adhesive disposed between the mounting block and the reticle.

The mounting block of the EUV pellicle may include a mounting spacing member 430 that may protrude and extend downward from the stress-absorbing body 410.

The second adhesive may be disposed between the mounting spacing member 430 and the reticle.

Additionally, the EUV exposure apparatus according to the embodiment may include a reticle and one of the EUV pellicle structures 2000 that fixes the pellicle on the reticle.

In addition, a method for mounting and demounting of the EUV pellicle according to the embodiment may include a mounting step of fixing one of the EUV pellicle structures 2000 on the reticle, a heating step of the stress-absorbing body 410, a lifting step of the stress-absorbing body 410 with a demounting jig, and a demounting step performed by moving the demounting jig horizontally.

The step of lifting the stress-absorbing body 410 may include inserting the demounting jig into the jig guide part R2 provided in the stress-absorbing body 410 to lift the stress-absorbing body 410.

In addition, the step of lifting the stress-absorbing body 410 may include lifting the stress-absorbing body 410 by inserting the demounting jig into the demounting slot 410S provided in the stress-absorbing body 410.

In the step of lifting the stress-absorbing body 410, the stress-absorbing body 410 may be elastically deformed.

In the step of lifting the stress-absorbing body 410, the stress-absorbing body 410 may be plastically deformed.

The step of heating the stress-absorbing body 410 may include a step of heating the stress-absorbing body by inserting a heating device into the mounting groove (H) provided in the stress-absorbing body 410.

In addition, a mounting and demounting method of EUV pellicle according to the second embodiment may include a mounting step of fixing one of the EUV pellicle structures 2000 on a reticle, a heating step of the stress-absorbing body 410 and a performing demounting by inserting a jig pin into the mounting groove (H) provided in the stress-absorbing body 410.

The demounting step may include a step of moving the jig pin inserted into the mounting groove (H) to the left and right within the mounting groove (H), and a step of demounting with the jig pin in a horizontal state.

### [Advantageous Effects]

The embodiment can provide with mounting blocks 400, 402, 403, 404, 405 of the EUV pellicle having a stress-absorbing structure, thereby there is a complex technical effect that can buffer or reduce the 'mechanical stress' applied to the pellicle frame and membrane border during the pellicle demounting step and the 'thermal stress' caused by the difference in coefficient of thermal expansion (CTE) during the exposure process.

First, the mounting block of the embodiment may include a stress-absorbing through-hole (T) penetrating from a top to a bottom of the stress-absorbing body 410. Accordingly, the mechanical stress generated when lifting the stress-absorbing body 410 with the demounting jig (JIG, 800) can be prevented from being transmitted to the pellicle frame 200 and the membrane border 305, thereby there is a special technical effect in that the pellicle 1000 can be demounted without damaging the pellicle membrane 310.

Also, according to the embodiment, since the mounting block may include a stress-absorbing through-hole (T), when lifting the stress-absorbing body 410 with a demounting jig , along the stress-absorbing through-hole (T), it can be lifted through elastic deformation or plastic deformation. Accordingly, there is a technical effect of absorbing or blocking mechanical stress through the stress-absorbing through-hole (T).

Next, according to the embodiment, since the mounting block may include a stress-absorbing through-hole (T), the heat of the adhesive heating step for demounting can be blocked from being transmitted to the pellicle frame 200 or the membrane border 305. Accordingly, the embodiment has a special technical effect that can protect the pellicle membrane from heat.

Next, according to the embodiment, it can prevent a PID (Pellicle Induced Distortion) from occurring due to the difference in the coefficient of thermal expansion (CTE) of the pellicle frame and the mask substrate that are in contact with each other, or the difference in the coefficient of thermal expansion (CTE) of the pellicle frame and the pellicle membrane.

For example, in an embodiment, thermal stress due to a difference in coefficient of thermal expansion (CTE) between the pellicle frame and the reticle can be blocked by the stress-absorbing through-hole (T) of the mounting block. Accordingly, there is a special technical effect of protecting the pellicle membrane from thermal stress by preventing thermal stress from being transmitted to the pellicle frame 200 or the membrane border 305.

Also, according to an embodiment, thermal stress due to a difference in coefficient of thermal expansion (CTE) between the pellicle frame and the pellicle membrane can be blocked by the stress-absorbing through-hole (T). Accordingly, there is a special technical effect of preventing the PID (Pellicle Induced Distortion) from occurring because thermal stress is not transmitted to the reticle 100.

Next, according to the embodiment, as a separation space (S) may be disposed between the pellicle frame 200 and the reticle 100 by the mounting block, there is a technical effect in that the pressure difference between the inside and outside of the pellicle can be resolved.

### [Description of Drawings]

FIG. 1 is a perspective view of an EUV pellicle structure 2000 according to an embodiment.
FIG. 2 is an enlarged perspective view of the first mounting block 400 having a stress-absorbing structure according to the embodiment shown in FIG. 1.
FIG. 3A is a bottom perspective view of the EUV pellicle structure 2000 shown in FIG. 1.
FIG. 3B is a detailed perspective view of the EUV pellicle structure shown in FIG. 3A.
FIG. 4A is a cross-sectional view of the EUV pellicle structure 2000 along line A-A' shown in FIG. 1.
FIG. 4B is a detailed cross-sectional view of the EUV pellicle structure 2000 shown in FIG 4A.
FIGS. 5A to 5C are reference views for explaining the mounting and demounting steps of the EUV pellicle structure 2000 according to an embodiment.
FIGS. 6A and 6B are examples of stress applied to the mounting block 400R of the comparative example and the pellicle frame 200R of the comparative example during demounting, respectively.
FIGS. 7A and 7B are examples of stress applied to the mounting block 400E of the embodiment and the pellicle frame 200E of the embodiment during demounting.
FIG. 8 is an exploded perspective view of the EUV pellicle structure 2000 including a second mounting block 402 having a stress-absorbing structure.
FIG. 9 is a perspective view of the third mounting block 403 provided with a stress-absorbing structure.
FIG. 10 is a cross-sectional view of the EUV pellicle structure 2002 according to the second embodiment.
FIG. 11 is a cross-sectional view of the EUV pellicle structure 2003 according to the third embodiment.

### [Mode for Invention]

Hereinafter, embodiments that can be specifically implemented to solve the above problems will be described with reference to the attached drawings.

In the description of the embodiment, in the case where it is described as being formed "above or below" each element, it includes both the upper or lower two elements being in direct contact with each other or one or more other elements being formed by being disposed between the two elements. Additionally, when expressed as "up or down," it can include not only the upward direction but also the downward direction based on one configuration.

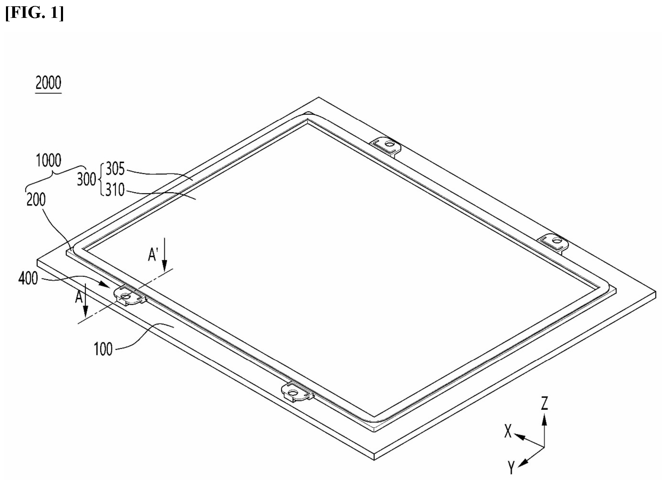

FIG. 1 is a perspective view of an EUV pellicle structure 2000 according to an embodiment.

The EUV pellicle structure 2000 according to the embodiment may include a fixed pellicle 1000, which is mounted on the reticle 100 by a mounting block 400 having a stress-absorbing structure and a mounting block 400 having a thermo-mechanical stress-absorbing structure.

The mounting block 400 having a stress-absorbing structure of the embodiment may be provided with a mechanical stress-absorbing structure. Additionally, the embodiment may include a mounting block for the EUV pellicle having a thermal stress-absorbing structure. Additionally, the embodiment may include a mounting block having a thermo-mechanical stress-absorbing structure.

The pellicle 1000 may include a pellicle frame 200 and a pellicle membrane 300. The pellicle membrane 300 may include a membrane border 305 and a pellicle membrane 310. The pellicle frame 200 forms an edge of the pellicle 1000 and may include a square frame shape, but is not limited to this.

In the example, 'thermo-mechanical stress' is a concept that includes ① 'thermal stress' caused by the difference in coefficient of thermal expansion (CTE) during the exposure process and ② 'mechanical stress' applied to the pellicle frame and membrane border during the mounting or demounting stage of the pellicle.

The 'first mounting block 400 having a thermo-mechanical stress-absorbing structure' of the embodiment may buffer or reduce the 'thermal stress' caused by the difference in coefficient of thermal expansion (CTE) during the exposure process and the 'mechanical stress' applied to the pellicle frame and membrane border during the mounting or demounting step of the pellicle.

The 'mounting block having a thermo-mechanical stress-absorbing structure' of the embodiment may be abbreviated as 'mounting block'.

The reticle 100 may have a mask pattern formed on a predetermined mask substrate. The extreme ultraviolet (EUV) exposure apparatus with a wavelength of 13.5 nm to which the embodiment is applied may have a reflective light source that does not transmit the reticle 100.

For example, in the EUV exposure apparatus to which the embodiment is applied, a predetermined exposure light source (not shown) may be injected into the reticle 100 and reflected, and a predetermined multi-layer thin film mirror may be provided on the mask substrate, but is not limited to this.

The pellicle 1000 according to the embodiment may be applied to EUV exposure equipment that uses extreme ultraviolet rays (EUV) as a light source. EUV exposure equipment may implement a finer integrated circuit than DUV (Deep Ultra Violet) exposure equipment. The EUV wavelength is 13.5 nm, which is shorter than DUV, and the shorter the wavelength, the less diffraction of light occurs. Therefore, EUV exposure equipment may pattern finer integrated circuits on semiconductor wafers. For example, EUV exposure equipment may be applied to the leading-edge process (7nm or less) of non-memory semiconductors or the DRAM process.

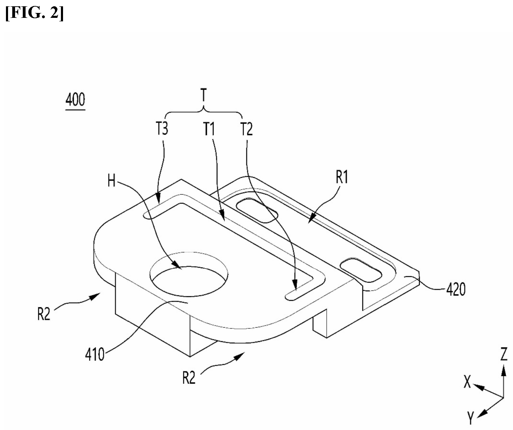

Next, FIG. 2 is an enlarged perspective view of the first mounting block 400 equipped with the stress-absorbing structure shown in FIG. 1.

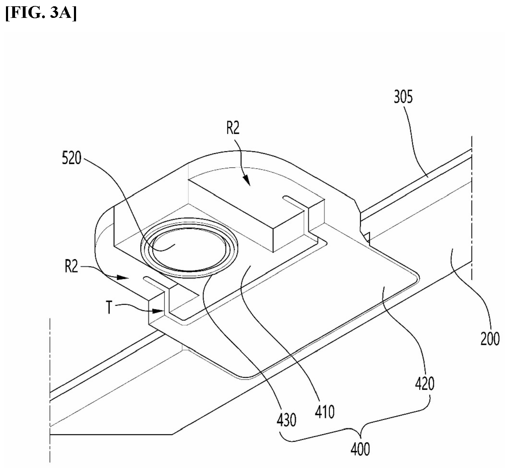

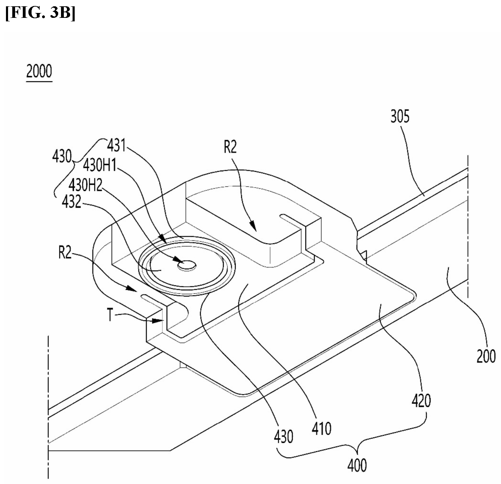

FIG. 3A is a bottom perspective view of the EUV pellicle structure 2000 shown in FIG. 1, and FIG. 3B is a detailed perspective view of the EUV pellicle structure shown in FIG. 3A.

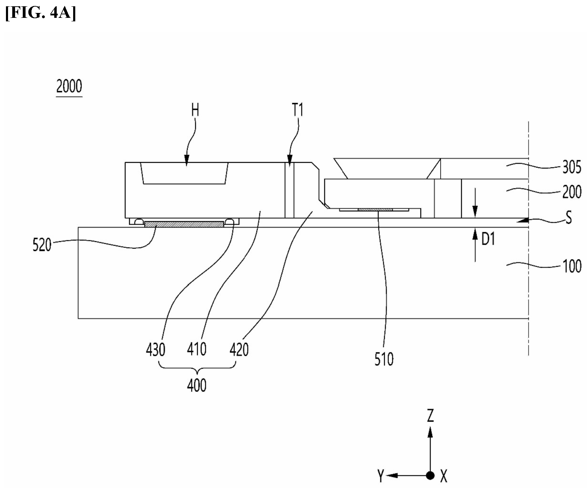

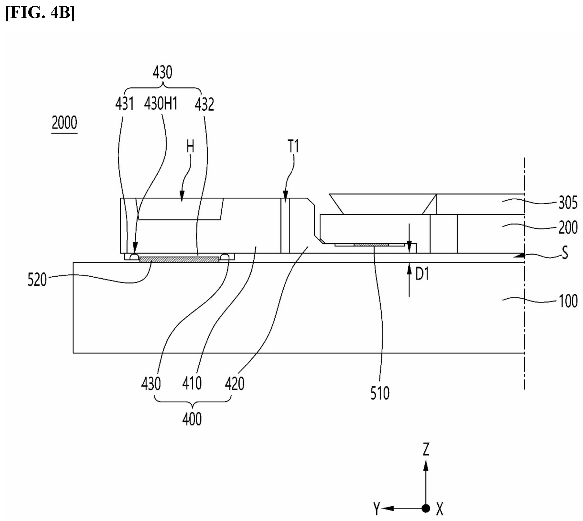

FIG. 4A is a cross-sectional view of the EUV pellicle structure 2000 taken along line A-A' shown in FIG. 1, and FIG. 4B is a detailed cross-sectional view of the EUV pellicle structure 2000 shown in FIG. 4A.

Hereinafter, the EUV pellicle structure 2000 including the first mounting block 400 will be described in detail with reference to FIGS. 2 to 4B.

First, referring to FIG. 2, the first mounting block 400 according to the embodiment may include a mounting frame 420 and a stress-absorbing body 410.

For example, the first mounting block 400 may include a mounting frame 420 disposed in a first direction (X), and a stress-absorbing body 410 extending from the mounting frame 420 in a second direction (Y) perpendicular to the first direction (X).

The mounting frame 420 may be provided with a first guide portion R1 on its upper surface.

Also, referring to FIGS. 3A and 3B, the first mounting block 400 may include a mounting spacing member 430 extending in the negative (-) direction of the third direction (Z) perpendicular to the first and second directions (X,Y).

The first mounting block 400 may include a metal material. For example, the first mounting block 400 may include Ti, Al, or an alloy thereof, but is not limited thereto.

The mounting frame 420, the stress-absorbing body 410, and the mounting spacing member 430 may be formed as one body, but are not limited thereto. For example, the first mounting block 400 may be formed through a plastic working process, but is not limited thereto. For example, the first mounting block 400 may be formed through a casting process or an extrusion process.

Continuing to refer to FIGS. 3A and 3B, the mounting spacing member 430 has a predetermined receiving groove, and a second adhesive 520 may be disposed in the receiving groove to secure the first mounting block 400 and the reticle 100.

For example, referring to FIG. 3B, the mounting spacing member 430 may include a first spacing frame 431 that protrudes downward from the stress absorbing body 410 and has a first receiving groove 430H1. The first spacing frame 431 may have a cylindrical shape, but is not limited thereto.

Additionally, the mounting spacing member 430 may include a second spacing frame 432 that protrudes downward from the stress absorbing body 410 and is disposed inside the first spacing frame 431. The second spacing frame 432 is not limited to having a cylindrical shape.

The first receiving groove 430H1 may be a space between the first spacing frame 431 and the second spacing frame 432, but is not limited thereto.

Additionally, the second spacing frame 432 of the mounting spacing member 430 may include a second receiving groove 430H2 at its bottom. For example, the second spacing frame 432 may include a second receiving groove 430H2 inwardly recessed at the center of its bottom.

The depth of the second receiving groove 430H2 may be lower than the depth of the first receiving groove 430H1, but is not limited thereto.

Referring to FIGS. 4A and 4B, a second adhesive 520 may be disposed on the mounting spacing member 430 to secure the first mounting block 400 and the reticle 100.

For example, the second adhesive 520 may be disposed on the second spacing frame 432 of the mounting spacing member 430 to fix the first mounting block 400 and the reticle 100.

According to the embodiment, the downward height of the first spacing frame 431 may be greater than the downward height of the second spacing frame 432.

That is, the first spacing frame 431 may be closer to the reticle 100 than the second spacing frame 432.

Accordingly, according to the embodiment, an accommodation space in which the second adhesive 520 may be stably positioned may be provided by the first spacing frame 431 and the second spacing frame 432.

In addition, the embodiment may be provided with a first receiving groove 430H1, which is a space between the first spacing frame 431 and the second spacing frame 432, so that the second adhesive 520 is used as a mounting spacing member 430 may be prevented from exceeding the outside.

In addition, in the embodiment, the second spaced frame 432 may include a second receiving groove 430H2 at the bottom, so that the second adhesive 520 may be stably fixed.

Continuing to refer to FIGS. 4A and 4B, a first adhesive 510 may be disposed on the first guide portion R1 on the mounting frame 420, and the first mounting block 400 and the pellicle frame 200 may be fixed by the first adhesive 510.

Referring again to FIGS. 2 and 3A, the first mounting block 400 may include a stress-absorbing through-hole (T) penetrating from a top to a bottom of the stress-absorbing body 410.

The stress-absorbing through-hole (T) may have a ' 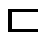 ' shape as shown in FIGS. 2 and 3A, but is not limited thereto.

For example, the stress-absorbing through-hole (T) may include a first stress-absorbing through-hole T1 extending in the first direction (X) and a second stress-absorbing through-hole T2 and/or a third stress-absorbing through-hole T3 extending from the first stress-absorbing through-hole T1 in a second direction (Y) perpendicular to the first direction (X).

For example, the stress-absorbing through-hole (T) may include a second stress-absorbing through-hole T2 extending from one end of the first stress-absorbing through-hole T1 in a second direction (Y) perpendicular to the first direction (X). Additionally, the stress-absorbing through-hole (T) may include a third stress-absorbing through-hole T3 extending in the second direction (Y) from another end of the first stress-absorbing through-hole T1.

First, the first mounting block 400 according to the embodiment may include a stress-absorbing through-hole (T) penetrating from the top to the bottom of the stress-absorbing body 410. Accordingly, as will be explained later, mechanical stress generated in the pellicle mounting or demounting step can be prevented from being transmitted to the pellicle frame 200, the membrane border 305, and the pellicle membrane 310. And there is a special technical effect in that the pellicle 1000 can be mounted or demounted without damaging the pellicle membrane 310.

Also, referring to FIGS. 4A and 4B, during the exposure process, the thermal stress caused by the difference in coefficient of thermal expansion (CTE) between the pellicle frame and the reticle can be blocked by the stress-absorbing through-hole (T) so that the thermal stress is not transmitted to the pellicle frame 200 or the membrane border 305. Because of this, there is a special technical effect that can protect the pellicle membrane from thermal stress.

Also, according to an embodiment, thermal stress due to a difference in coefficient of thermal expansion (CTE) between the pellicle frame and the pellicle membrane can be blocked by the stress-absorbing through-hole (T). Accordingly, there is a special technical effect of preventing a PID (Pellicle Induced Distortion) from occurring because thermal stress is not transmitted to the reticle 100.

Next, referring to FIGS. 2 and 3A, the first mounting block 400 may include a mounting groove (H) disposed on an upper portion of the stress-absorbing body 410.

The mounting groove (H) may vertically overlap the mounting spacing member 430.

Additionally, the mounting groove (H) may vertically overlap the receiving groove of the mounting spacing member 430.

Additionally, the mounting groove (H) may vertically overlap the second adhesive 520 disposed on the mounting spacing member 430.

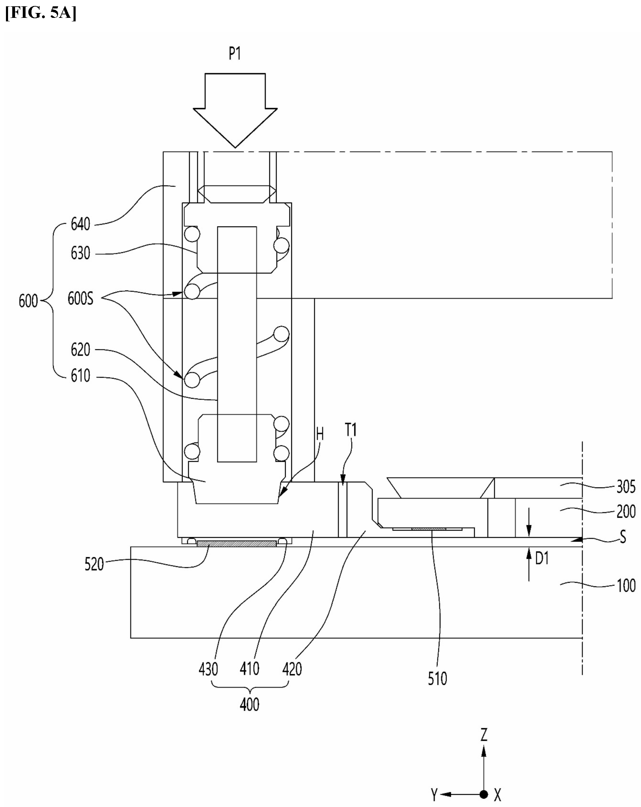

According to the embodiment, there is a technical effect that in the 'mounting step', the bonding between the second adhesive 520 and the reticle 100 can be strengthened by pressing the mounting groove H of the stress-absorbing body 410 with a press device 600 (see FIG. 5A).

The first mounting block 400 according to the embodiment may include a stress-absorbing through-hole (T) penetrating from the top to the bottom of the stress-absorbing body 410. Accordingly, in the embodiment, the mechanical stress generated by pressing the mounting groove (H) of the stress-absorbing body 410 with the press device 600 can be prevented from being transmitted to the pellicle frame 200, and the membrane border 305. So, there is a technical effect in that the pellicle 1000 can be mounted without damaging the pellicle membrane 310.

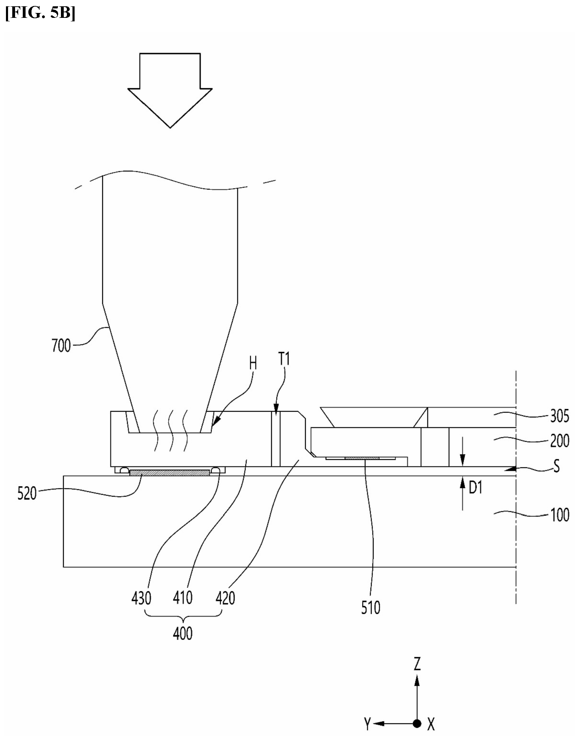

Also, according to the embodiment, there are complex technical effects that in the 'demounting step', demounting can be easily performed by inserting a predetermined heating device 700 (See FIG. 5B) into the mounting groove (H) of the stress-absorbing body 410 to heat the first mounting block 40 and the second adhesive 520.

Continuing to refer to FIGS. 2 and 3A, the first mounting block 400 may include a single or a plurality of jig guide portions R2 disposed below the stress absorbing body 410.

The jig guide portion R2 may provide a jig space for demounting, as can be seen in the demounting step described later.

In addition, since the area of the jig guide portion R2 is an empty space area where a significant portion of the stress-absorbing body 410 is removed or absent, there is an effect in that the stress-absorbing through-hole (T) can be formed accurately and efficiently.

Next, referring to FIG. 4A, the first thickness of the mounting frame 420 in the first mounting block 400 may be thinner than the second thickness of the stress-absorbing body 410.

Additionally, in the first mounting block 400, the mounting spacing member 430 may protrude downward from the stress-absorbing body 410.

According to the embodiment, as the mounting spacing member 430 protrudes downward from the stress absorbing body 410, a separation space (S) may be disposed between the pellicle frame 200 and the reticle 100 at a first distance D1 by the mounting spacing member 430. At this time, the height of the separation space (S) may be controlled by the thickness of the mounting spacing member 430. The first distance D1 may be smaller than the size of the external particle.

According to the embodiment, a complex technical effect in which the pressure difference between the inside and outside of the pellicle can be resolved by disposing a separation space (S) between the pellicle frame 200 and the reticle 100 by the first mounting block 400 to secure the pellicle to the reticle.

Next, FIGS. 5A to 5C are reference drawings for explaining the mounting and demounting steps of the EUV pellicle structure 2000 according to an embodiment.

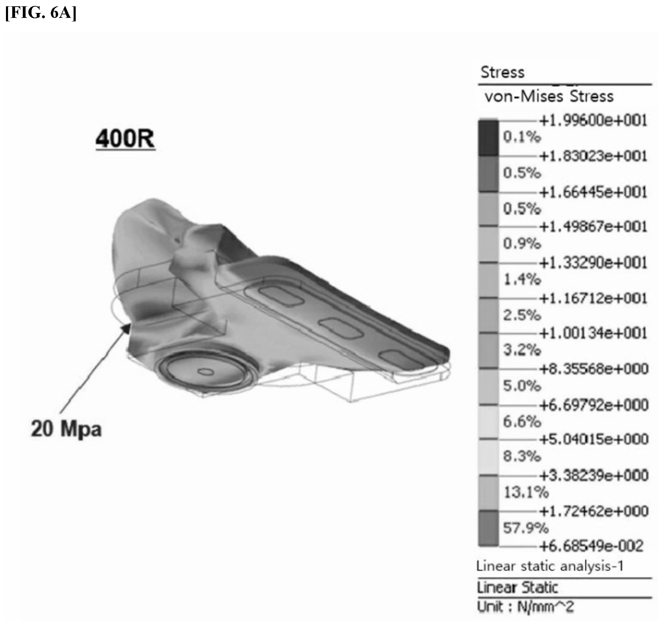

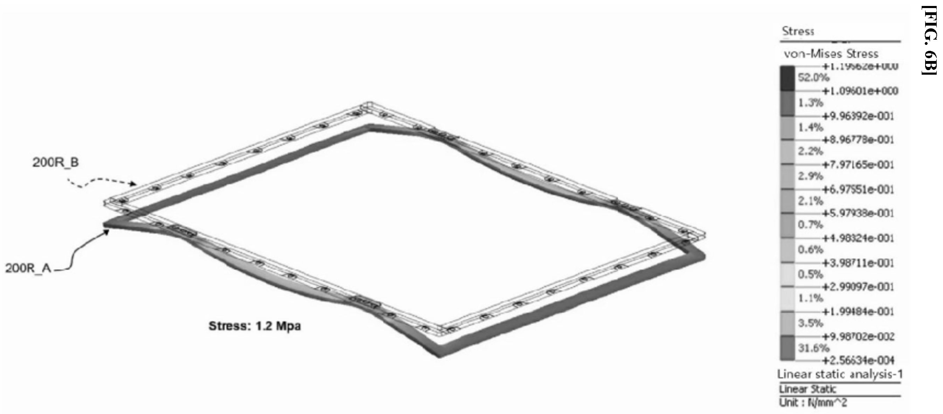

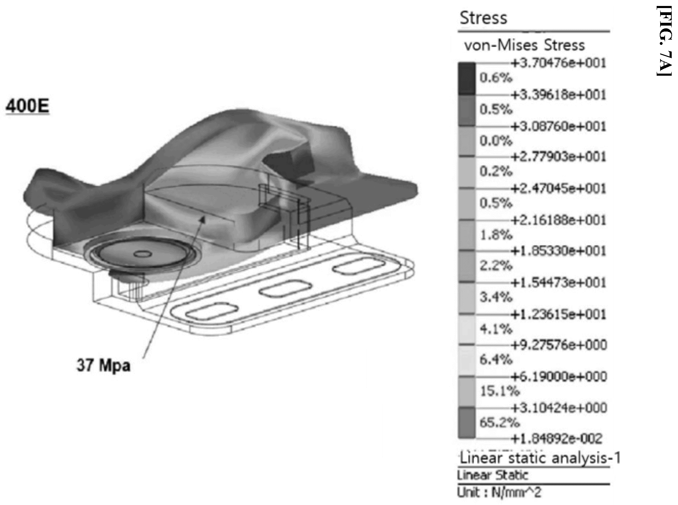

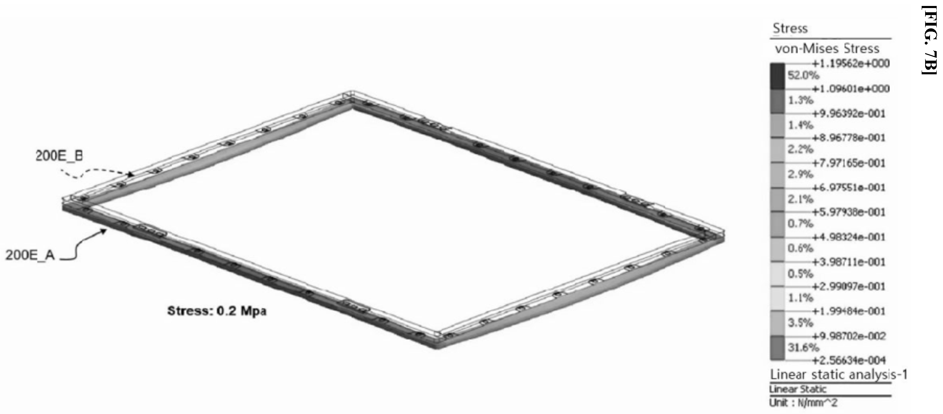

In addition, FIGS. 6A and 6B are illustrations of stress applied to the mounting block 400R of the comparative example and the pellicle frame 200R of the comparative example during demounting. And FIGS. 7A and 7B are examples of stress applied to the mounting block 400E of the embodiment and the pellicle frame 200E of the embodiment during demounting.

Hereinafter, with reference to FIGS. 2 to 7B, the first mounting and demounting method of the EUV pellicle structure 2000 according to the embodiment will be described.

First, the mounting step of fixing the EUV pellicle structure 2000 on the reticle 100 will be described with reference to FIG. 5A.

In the 'mounting step' of the embodiment, mounting is performed by pressing the press device 600 in the mounting groove (H) of the first mounting block 400, thereby there is a technical effect in that the bonding between the second adhesive 520 and the reticle 100 can be strengthened.

For example, the press device 600 may include a press pin 610, a pressing frame 620, a press unit 630, an elastic portion 600S, and a press cover 640.

For example, with the press pin 610 of the press unit 630 inserted into the mounting groove (H) of the first mounting block400, the press unit 630 may press along the pressing frame 620 to transmit the first load P1 in the downward direction (-Z) to the press pin. For example, in the embodiment, the first load P1 may be transmitted to the press pin 610 by an elastic portion 600S disposed between the press pin 610 and the press unit 630, for example, a spring.

The pressure of the press unit 630 may be applied by mechanical pressure such as hydraulic pressure or a step motor, but is not limited to this.

Next, a method of demounting the EUV pellicle structure 2000 from the reticle 100 will be described with reference to FIGS. 5B to 5C.

Referring to FIG. 5B, the 'demounting step' of the embodiment may heat the first mounting block 400 by inserting the heating device 700 into the mounting groove (H) of the stress-absorbing body 410. At this time, the second adhesive 520 may be also heated above a predetermined phase transition temperature (Tg) and the bonding force between the first mounting block 400 and the reticle 100 is lowered, so there is a technical effect in that demounting can be easily performed. The heating device 700 may be heated using a heat ray or an ultrasonic device, but is not limited thereto.

Additionally, in the embodiment, the material of the first mounting block 400 may be a material with higher thermal conductivity than the pellicle frame 200 or the membrane border 305. Accordingly, the stress-absorbing body 410 may be heated quickly in the heating step, and the heated heat may not be transmitted to the pellicle frame 200 or the membrane border 305.

Also, according to the embodiment, the heat for heating the adhesive can be blocked by the stress-absorbing through-hole (T) and may not transmitted to the pellicle frame 200 or the membrane border 305, thereby there is a special technical effect that can protect the pellicle membrane from heat.

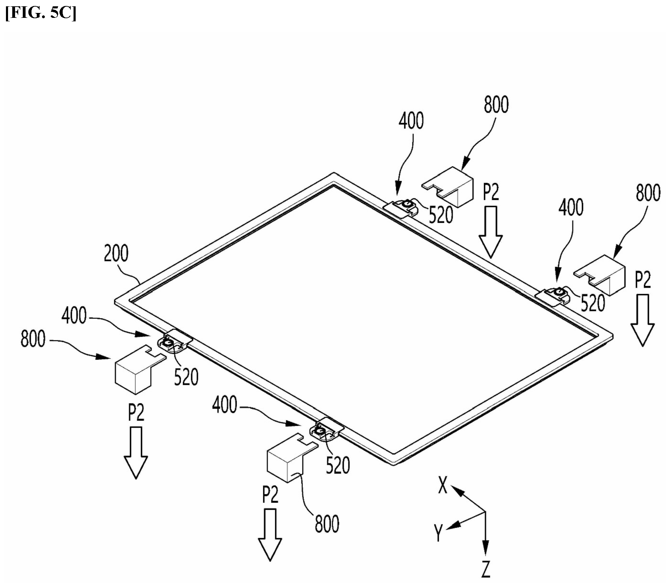

Next, FIG 5C is an example diagram of the step of demounting the EUV pellicle structure 2000 using a demounting jig 800. For convenience of explanation, the EUV pellicle structure 2000 in FIG. 5C is shown in a 180° inverted state with the bottom of the pellicle frame 200 and the bottom of the first mounting block 400 facing upward, and the pellicle membrane (300) is omitted.

Referring to FIG. 5C, the first mounting block 400 according to the embodiment may perform demounting of the EUV pellicle structure 2000 using the lever principle.

For example, the stress-absorbing body 410 may be lifted by inserting the jig 800 for demounting into the jig guide portion R2 of each first mounting block 400 and applying the second load P2 which is in the upward direction (+Z) based on the reticle 100 and in the downward direction (+Z) based on FIG. 5C. At this time, the second adhesive 520 may be separated from the reticle 100 from the inside.

When lifting the first mounting block 400 with the demounting jig 800, the first mounting block 400 may be elastically deformed or plastically deformed, but is not limited thereto.

According to the embodiment, the first mounting block 400 includes a stress-absorbing through-hole (T) penetrating from the top to the bottom of the stress-absorbing body 410. Accordingly, it is possible to prevent mechanical stress generated when lifting the stress-absorbing body 410 with the demounting jig 800 from being transmitted to the pellicle frame 200 and the membrane border 305, and ultimately, there is a special technical effect of being able to demount the pellicle 1000 without damaging the pellicle membrane 310.

For example, FIGS. 6A and 6B are examples of stress tests applied to the mounting block 400R of the comparative example and the pellicle frame 200R of the comparative example during demounting, respectively. The mounting block 400R of the comparative example is simply one that does not have the stress-absorbing through-hole (T) in the mounting block 400E of the embodiment, and the mounting block 400R of the comparative example is not a known technology but merely an undisclosed internal technology.

Next, FIGS. 7A and 7B are examples of stress tests applied to the mounting block 400E of the embodiment and the pellicle frame 200E of the embodiment during demounting. The mounting block 400E of the embodiment may be the first mounting block 400 described above, but is not limited thereto, and may include the second, third, fourth, and fifth mounting blocks 402, 403, 404, and 405 described later.

Table 1 below shows stress data applied during demounting to the mounting block and pellicle frame in Comparative Examples and Embodiments, respectively.

**[Table 1]**

| Model | Comparative Example | Embodiment |
|---|---|---|
| Mounting block | 20 Mpa | 37 Mpa |
| Pellicle frame | 1.2 Mpa | 0.2 Mpa |

First, referring to FIG 6A, when the pellicle structure equipped with the mounting block (400R) of the comparative example is demounted, a stress of about 20Mpa is applied to the mounting block (400R) of the comparative example, and referring to FIG. 6B, a stress of about 1.2 Mpa is applied to the pellicle frame 200R of the comparative example. Since the mounting block 400R of the comparative example was not provided with a stress-absorbing structure, significant stress was transmitted to the pellicle frame.

In particular, referring to FIG. 6B, the pellicle frame 200R_B of the comparative example before stress is applied is in a flat state.

On the other hand, after stress for demounting was applied to the pellicle structure on which the mounting block 400R of the comparative example was mounted, the pellicle frame 200R_A of the comparative example was significantly deformed.

For this reason, in the case of the comparative example, although a relatively low stress of about 20 Mpa was applied to the mounting block 400R of the comparative example compared to the embodiment, a high stress of about 1.2 Mpa was applied to the pellicle frame 200R of the comparative example. Accordingly, there is a problem that the pellicle membrane is damaged as the pellicle frame 200R of the comparative example is deformed.

On the other hand, referring to FIG. 7A, when the pellicle structure on which the mounting block 400E of the embodiment is mounted is demounted, a high stress of about 37Mpa is applied to the mounting block 400E of the embodiment compared to the comparative example, so that demounting can be carried out efficiently. Mounting can proceed efficiently. Also, referring to FIG. 7B, only a very low stress of about 0.2 Mpa is applied to the pellicle frame 200E of the embodiment, which means that only a very low stress of about 1/6 level is transmitted to the pellicle frame 200E compared to the comparative example.

Accordingly, referring to FIG. 7B, the pellicle frame 200E_B of the embodiment before stress is applied is in a flat state. In addition, the pellicle frame 200E_A of the embodiment after stress for demounting is applied to the pellicle structure on which the mounting block 400E of the embodiment is mounted shows almost no deformation compared to the comparative example.

Accordingly, according to the embodiment, the first mounting block 400 may include a stress-absorbing through-hole (T) in the stress-absorbing body 410, and thus when lifting the stress-absorbing body 410 with the demounting jig 800, it may be lifted by efficient elastic deformation or plastic deformation while generating less mechanical stress along the line of the first stress-absorbing through-hole T1. Accordingly, there is a technical effect of absorbing or blocking mechanical stress.

Next, the demounting jig 800 moves horizontally at the height at which the first mounting block 400 is lifted, and demounting may be performed by applying force to the front in a horizontal state.

Also, with reference to FIGS. 5A to 5B, a second method of mounting and demounting the EUV pellicle structure 2000 according to another embodiment will be described.

First, like the first method, the 'mounting step' of the second method may be performed by pressing the press device 600 in the mounting groove (H) of the first mounting block 400.

Next, as shown in FIG. 5B, the heating device 700 may be inserted into the mounting groove (H) of the stress-absorbing body 410 to heat the first mounting block 400 and the second adhesive 520..

Next, insert a jig pin (not shown) into the mounting groove (H) of the stress-absorbing body 410, move it left and right within the mounting groove (H), and by applying force to the front in a horizontal state demounting may be done.

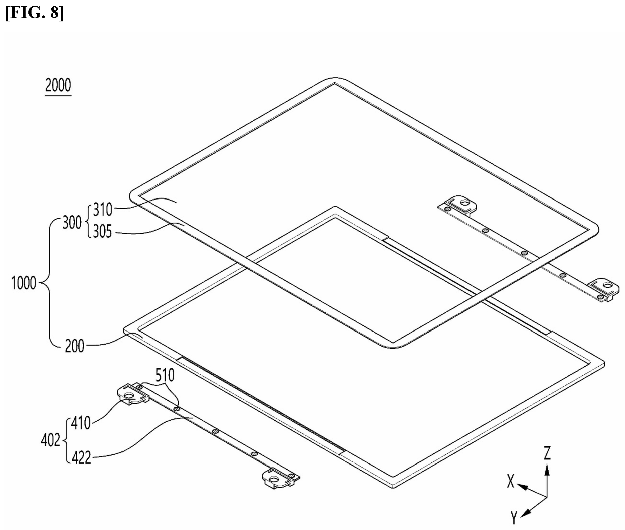

Next, FIG. 8 is an exploded perspective view of the EUV pellicle structure 2000 including the second mounting block 402.

The second mounting block 402 may adopt the technical features of the first mounting block 400, and will be described below focusing on the features of the second mounting block 402.

The second mounting block 402 may include a mounting connection frame 422 extending in the first direction (X) and a stress-absorbing body 410 disposed on one or both sides of the mounting connection frame 422. Like the first mounting block 400, the second mounting block 402 may include a mounting spacing member 430 below the stress-absorbing body 410.

The area of the mounting connection frame 422 in contact with the stress absorbing body 410 in the second mounting block 402 performs the function of the mounting frame 420 of the first mounting block 400 described above, but are not limited thereto.

The mounting connection frame 422 and the stress-absorbing body 410 may be formed integrally, but are not limited thereto. A first adhesive 510 may be disposed on the mounting connection frame 422.

The second mounting block 402 may also be made of a metal material such as Ti, Al, or an alloy thereof. Additionally, the second mounting block 402 may be formed through a plastic working process, but is not limited thereto, and may also be formed through a casting process or an extrusion process.

The second mounting block 402 has the technical effect of improving mechanical strength by providing the mounting connection frame 422.

In addition, the second mounting block 402 can improve the fixing force of the pellicle by expanding the coupling fixing area by providing the mounting connection frame 422.

In addition, the second mounting block 402 includes the mounting connection frame 422, which has the technical effect of preventing mechanical damage to the pellicle frame and pellicle border by applying distributed force to the pellicle frame during the demounting process.

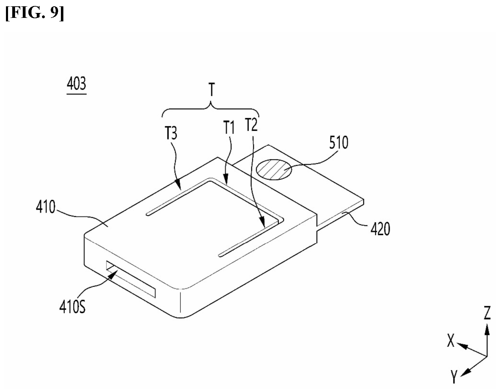

Next, FIG. 9 is a perspective view of the third mounting block 403.

The third mounting block 403 may adopt the technical features of the first mounting block 400 or the second mounting block 402, and hereinafter, the main features of the third mounting block 403 will be described.

The third mounting block 403 may include a mounting frame 420 disposed in a first direction (X), and a stress-absorbing body 410 disposed to extend in a second direction (Y) perpendicular to the first direction (X). Like the first mounting block 400, the third mounting block 403 may further include a mounting spacing member 430 below the stress absorbing body 410.

A first adhesive 510 may be disposed on the mounting frame 420, and a second adhesive 520 may be disposed on the mounting spacing member 430.

The mounting frame 420 and the stress-absorbing body 410 may be formed integrally, and the third mounting block 403 may be formed of a metal material such as Ti, Al, or an alloy thereof, but is not limited thereto.

The third mounting block 403 may include a single or a plurality of demounting slots 410S on a side of the stress-absorbing body 410.

In the embodiment, the third mounting block 403 may be made of a material with higher thermal conductivity than the pellicle frame 200 or the membrane border 305. Accordingly, the stress-absorbing body 410 may be quickly heated in the heating step for demounting, and the heated heat is not transmitted to the pellicle frame 200 or the membrane border 305, thereby there is a technical effect that can protect the pellicle membrane.

Hereinafter, with reference to FIG. 9, features of the third demounting method of the EUV pellicle structure 2000 equipped with the third mounting block 403 according to the embodiment will be described.

First, in the demounting step, the stress-absorbing body 410 and the second adhesive 520 may be heated using the heating device 700.

According to the embodiment, the third mounting block 403 may include a stress-absorbing through-hole (T). Accordingly, the heat from the heating step is blocked from being transmitted to the pellicle frame 200 or the membrane border 305, which has a special technical effect of protecting the pellicle membrane from heat.

Next, the third mounting block 403 according to the embodiment may also be operated by the lever principle.

For example, the stress-absorbing body 410 may be lifted by plastic deformation or elastic deformation by inserting the demounting jig 800 into the demounting slot 410S, and the second adhesive 520 may be separated from the reticle 100.

Next, the demounting jig 800 moves horizontally at the height at which the third mounting block 403 is lifted, and demounting can be performed by applying force to the front in a horizontal state.

According to the embodiment, since the third mounting block 403 includes a stress-absorbing through-hole (T) penetrating from the top to the bottom of the stress-absorbing body 410, mechanical stress generated when lifting the stress-absorbing body 410 with the demounting jig 800 may be prevented from being transmitted to the pellicle frame and membrane border. Accordingly, there is a special technical effect of being able to demount the pellicle 1000 without damaging the pellicle membrane.

Also, according to the embodiment, since the third mounting block 403 includes a stress-absorbing through-hole (T), when lifting the stress-absorbing body 410 with the demounting jig 800, there is a technical effect that it can be lifted while efficiently reducing mechanical stress along the stress-absorbing through-hole (T) line.

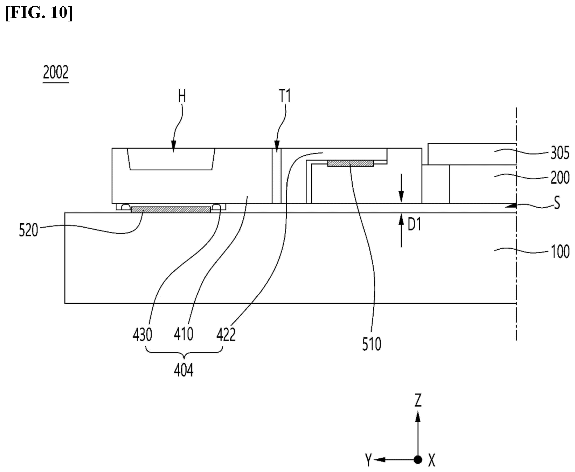

Next, FIG. 10 is a cross-sectional view of the EUV pellicle structure 2002 according to the second embodiment.

The EUV pellicle structure 2002 according to the second embodiment may adopt the technical features of the EUV pellicle structure 2000 described above, and hereinafter, the description will focus on the features of the EUV pellicle structure 2002 according to the second embodiment.

The EUV pellicle structure 2002 according to the second embodiment may include a fourth mounting block 404 having a stress-absorbing structure.

The fourth mounting block 404 may adopt the technical features of the first to third mounting blocks 400, 402, and 403, and hereinafter, the main features of the fourth mounting block 404 will be described.

The fourth mounting block 404 may include a second mounting frame 422 disposed in the first direction (X), and a stress-absorbing body 410 extending from the second mounting frame 422 in a second direction (Y) perpendicular to the first direction (X), and a stress-absorbing through-hole penetrating from the top to the bottom of the stress-absorbing body 410.

The stress-absorbing through-holes may include a first stress-absorbing through-hole T1, a second stress-absorbing through-hole T2, and a third stress-absorbing through-hole T3 disposed in the stress-absorbing body 410 described above.

Unlike the first to third mounting blocks 400, 402, and 403, in the fourth mounting block 404, the second mounting frame 422 may extend from an upper side of the stress absorbing body 410.

The upper surface of the second mounting frame 422 and the upper surface of the stress-absorbing body 410 may be at the same height, but are not limited to this.

The EUV pellicle structure 2002 according to the second embodiment may include a first adhesive 510 disposed between the bottom surface of the second mounting frame 422 and the pellicle frame 200.

Additionally, the EUV pellicle structure 2002 according to the second embodiment may include a second adhesive 520 disposed between the mounting spacing member 430 and the reticle 100.

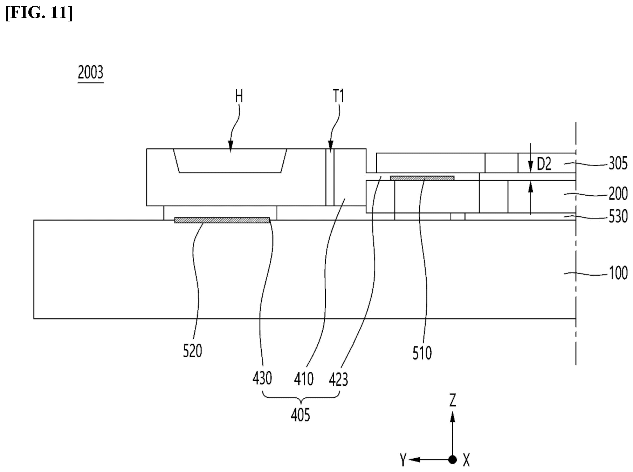

Next, FIG. 11 is a cross-sectional view of the EUV pellicle structure 2003 according to the third embodiment.

The EUV pellicle structure 2003 according to the third embodiment may adopt the technical features of the EUV pellicle structures 2000, 2002 described above, and hereinafter, the description will focus on the features of the EUV pellicle structure 2003 according to the third embodiment.

The EUV pellicle structure 2003 according to the third embodiment may include a fifth mounting block 405 having a stress-absorbing structure.

The fifth mounting block 405 may adopt the technical features of the first to fourth mounting blocks 400, 402, 403, and 404, and hereinafter, the description will focus on the main features of the fifth mounting block 405.

The fifth mounting block 405 may include a third mounting frame 423 disposed in the first direction (X), a stress-absorbing body 410 extending from the third mounting frame 423 in a second direction (Y) perpendicular to the first direction (X) and a stress-absorbing through-hole passing from the top to the bottom of the stress-absorbing body 410

The stress-absorbing through-holes may include a first stress-absorbing through-hole T1, a second stress-absorbing through-hole T2, and a third stress-absorbing through-hole T3 disposed in the stress-absorbing body 410 described above.

Unlike the first to fourth mounting blocks 400, 402, 403, and 404, in the fifth mounting block 405, the third mounting frame 423 may extend from the middle side of the stress-absorbing body 410.

For example, the third mounting frame 423 of the fifth mounting block 405 may be disposed between the pellicle frame 200 and the membrane border 305.

The EUV pellicle structure 2003 according to the third embodiment may form a second separation space D2 between the pellicle frame 200 and the membrane border 305.

The EUV pellicle structure 2003 according to the third embodiment has the technical effect of controlling the size of the second separation space D2 through the thickness of the third mounting frame 423.

The EUV pellicle structure 2003 according to the third embodiment may include a predetermined filter in the second separation space D2, but is not limited thereto.

The EUV pellicle structure 2003 according to the third embodiment may include a first adhesive 510 disposed between the bottom surface of the third mounting frame 423 and the pellicle frame 200.

Additionally, the EUV pellicle structure 2003 according to the third embodiment may include a second adhesive 520 disposed between the mounting spacing member 430 and the reticle 100.

The EUV pellicle structure 2003 according to the third embodiment may place an elastic material or rubber, etc. between the reticle 100 and the pellicle frame 200, but is not limited thereto.

Since the embodiment is provided with a mounting block of the EUV pellicle having a stress-absorbing structure, there is a complex technical effect that can buffer or reduce the 'mechanical stress' applied to the pellicle frame and membrane border during the mounting or demounting step of the pellicle and the 'thermal stress' caused by the difference in coefficient of thermal expansion (CTE) during the exposure process.

For example, the mounting block of the embodiment may include a stress-absorbing through-hole (T) penetrating from the top to the bottom of the stress-absorbing body 410. Accordingly, it is possible to prevent mechanical stress generated when lifting the stress-absorbing body 410 with a demounting jig from being transmitted to the pellicle frame 200 and the membrane border 305. Accordingly, there is a special technical effect in that the pellicle 1000 can be demounted without damaging the pellicle membrane 310.

Also, according to the embodiment, since the mounting block includes a stress-absorbing through-hole (T), when lifting the stress-absorbing body 410 with a demounting jig, it can be lifted through elastic deformation or plastic deformation along the stress-absorbing through-hole (T), and has the technical effect of absorbing or blocking mechanical stress.

Also, according to the embodiment, since the mounting block includes a stress-absorbing through-hole (T), there is a special technical effect of protecting the pellicle membrane from heat by blocking the heat from the adhesive heating step for demounting from being transmitted to the pellicle frame 200 or the membrane border 305.

Also, according to the embodiment, there is a technical effect of preventing PID (Pellicle Induced Distortion) from occurring due to the difference in the coefficient of thermal expansion (CTE) of the pellicle frame and the mask substrate that are in contact with each other, or the difference in the coefficient of thermal expansion (CTE) of the pellicle frame and the pellicle membrane.

For example, in the embodiment, thermal stress due to a difference in coefficient of thermal expansion (CTE) between the pellicle frame and the reticle may be blocked by the stress-absorbing through-hole (T) of the mounting block. Accordingly, thermal stress is not transmitted to the pellicle frame 200 or the membrane border 305, which has a special technical effect of protecting the pellicle membrane from thermal stress.

Also, according to the embodiment, thermal stress due to the difference in coefficient of thermal expansion (CTE) between the pellicle frame and the pellicle membrane is blocked by the stress-absorbing through-hole (T), so that thermal stress is not transmitted to the reticle 100, which has a special technical effect that can prevent PID (Pellicle Induced Distortion) from occurring.

In addition, as a separation space (S) is created between the pellicle frame 200 and the reticle 100 by the mounting block of the embodiment, there is a technical effect in that the pressure difference between the inside and outside of the pellicle can be resolved.

The features, structures, effects, etc. described in the embodiments above are included in at least one embodiment and are not necessarily limited to only one embodiment. Furthermore, the features, structures, effects, etc. illustrated in each embodiment may be combined or modified and implemented in other embodiments by a person with ordinary knowledge in the field to which the embodiments belong. Therefore, contents related to such combinations and modifications should be interpreted as being included in the scope of the embodiments.

Although the above description focuses on the embodiments, this is only an example and does not limit the embodiments, and anyone with ordinary knowledge in the field to which the embodiment belongs will know that various modifications and applications not exemplified above are possible without departing from the essential features of the present embodiment. For example, each element specifically shown in the embodiments may be modified and implemented. And these variations and differences related to application should be interpreted as being included in the scope of the embodiments set forth in the appended claims.

### [Industrial Applicability]

In the embodiment, in the manufacture of semiconductor devices or liquid crystal displays, a photolithography process may be used when patterning a semiconductor wafer or liquid crystal substrate.

For example, the pellicle of the embodiment may be applied to an extreme ultraviolet (EUV) exposure process, but is not limited thereto.

## Claims

1. A mounting block for an EUV pellicle having a stress-absorbing structure, comprising:
a mounting frame disposed in a first direction;
a stress-absorbing body extending from the mounting frame in a second direction perpendicular to the first direction; and
a stress-absorbing through-hole configured to penetrate from a top to a bottom of the stress-absorbing body.

2. The mounting block for an EUV pellicle having a stress-absorbing structure according to claim 1, wherein the stress-absorbing through-hole includes a first stress-absorbing through-hole extending in the first direction and disposed in the stress-absorbing body.

3. The mounting block for an EUV pellicle having a stress-absorbing structure according to claim 2, wherein the stress-absorbing through-hole comprises
a second stress-absorbing through-hole extending from one end of the first stress-absorbing through-hole in the second direction perpendicular to the first direction; and
a third stress-absorbing through-hole extending from another end of the first stress-absorbing through-hole in the second direction.

4. The mounting block for an EUV pellicle having a stress-absorbing structure according to claim 1, wherein the mounting frame includes a first guide portion on its upper surface.

5. The mounting block for an EUV pellicle having a stress-absorbing structure according to claim 1, further comprising a mounting spacing member extending from the stress-absorbing body in a negative (-) direction of a third direction perpendicular to the first and second directions.

6. The mounting block for an EUV pellicle having a stress-absorbing structure according to claim 5, wherein the mounting spacing member includes an adhesive receiving groove.

7. The mounting block for an EUV pellicle having a stress-absorbing structure according to claim 6, further comprising a mounting groove disposed on an upper part of the stress-absorbing body.

8. The mounting block for an EUV pellicle having a stress-absorbing structure according to claim 7, wherein the mounting groove is configured to vertically overlap the adhesive receiving groove of the mounting spacing member.

9. The mounting block for an EUV pellicle having a stress-absorbing structure according to claim 4, wherein the mounting spacing member is configured to protrude from a bottom side of the stress-absorbing body.

10. The mounting block for an EUV pellicle having a stress-absorbing structure according to claim 1, further comprising a single or plural jig guide portion disposed on the bottom side of the stress-absorbing body.

11. The mounting block for an EUV pellicle having a stress-absorbing structure according to claim 10, wherein the jig guide portion is disposed in an opposite direction to the mounting frame.

12. The mounting block for an EUV pellicle having a stress-absorbing structure according to claim 1, further comprising a mounting connection frame connecting the stress-absorbing body.

13. The mounting block for an EUV pellicle having a stress-absorbing structure according to claim 1, wherein the stress-absorbing body includes a single or multiple demounting slots on its side.

14. The mounting block for an EUV pellicle having a stress-absorbing structure according to claim 13, wherein the demounting slot is disposed in an opposite direction to the mounting frame.

15. An EUV pellicle structure configured to fix a pellicle frame on a reticle by a mounting block, wherein the mounting block comprise the mounting block of the EUV pellicle provided with the stress-absorbing structure of any one of claims 1 to 14.

16. The EUV pellicle structure according to claim 15, further comprising a first adhesive disposed between the mounting frame and the pellicle frame.

17. The EUV pellicle structure according to claim 16, further comprising a second adhesive disposed between the reticle and the mounting block of the EUV pellicle having the stress-absorbing structure.

18. The EUV pellicle structure according to claim 17, wherein the mounting block of the EUV pellicle having the stress-absorbing structure includes a mounting spacing member configured to protrude and extend downward from the stress-absorbing body, and
wherein the second adhesive is disposed between the mounting spacing member and the reticle.

19. An EUV exposure apparatus comprising:
a reticle; and
the EUV pellicle structure according to claim 15, which is configured to fix the reticle and the pellicle.

20. A mounting and demounting method of an EUV pellicle, comprising:
a mounting step of fixing the EUV pellicle structure according to claim 15 on a reticle;
a heating step of the stress-absorbing body;
a lifting step of the stress-absorbing body with a demounting jig; and
a performing demounting step by moving the demounting jig horizontally.

21. The mounting and demounting method of EUV pellicle according to claim 20, wherein the step of lifting the stress-absorbing body includes inserting the demounting jig into a jig guide provided on the stress-absorbing body to lift the stress-absorbing body.

22. The mounting and demounting method of EUV pellicle according to claim 20, wherein the step of lifting the stress-absorbing body includes a step of inserting the demounting jig into a demounting slot provided in the stress-absorbing body to lift the stress-absorbing body.

23. The mounting and demounting method of EUV pellicle according to claim 20, wherein in the step of lifting the stress-absorbing body, the stress-absorbing body is elastically deformed.

24. The mounting and demounting method of EUV pellicle according to claim 20, wherein in the step of lifting the stress-absorbing body, the stress-absorbing body is plastically deformed.

25. The mounting and demounting method of EUV pellicle according to claim 20, wherein the step of heating the stress-absorbing body includes a step of inserting a heating device into a mounting groove provided in the stress-absorbing body to heat the stress-absorbing body.

26. A mounting and demounting method of an EUV pellicle, comprising:
a mounting step of fixing the EUV pellicle structure according to claim 15 on the reticle;
a heating step of the stress-absorbing body; and
a performing demounting step by inserting a jig pin into the mounting groove provided in the stress-absorbing body.

27. The mounting and demounting method of EUV pellicle according to claim 26, wherein the demounting step includes a step of moving the jig pin inserted into the mounting groove to left and right sides within the mounting groove, and demounting the jig pin in a horizontal state.
